# EUROPEAN PATENT APPLICATION

(11) **EP 1 901 579 A2**
(43) Date of publication of application: **19.03.2008**
(21) Application number: 07017239.0
(22) Date of filing: 03.09.2007
(51) Int. Cl.: H04R 1/06, H04R 1/08

(54) **Microphone module and mounting structure adapted to portable electronic device**

(30) Priority: 08.09.2006 JP 2006244268
(71) Applicant: YAMAHA CORPORATION, Naka-ku Hamamatsu-shi Shizuoka-ken (JP)
(72) Inventor: Kato, Hirokazu, Shizuoka-ken (JP); Suzuki, Toshihisa, Shizuoka-ken (JP)
(74) Representative: Emde, Eric

(57) **Abstract**

A microphone module is mounted on a mount portion of a circuit board incorporated in a portable electronic device, wherein it includes a housing having a hollow cavity and a sound hole for communicating the hollow cavity with the exterior, a microphone chip for detecting sound in the hollow cavity, a plurality of external connection terminals electrically connected to the microphone chip, and a plurality of extended portions that are horizontally extended from the housing in a direction perpendicular to the opening direction of the sound hole. The external connection terminals are formed on the surfaces of the extended portions; and the housing partially projects from the surfaces of the extended portions.

## Description

### BACKGROUND OF THE INVENTION

### Field of the Invention

The present invention relates to microphone modules for receiving and detecting sounds. The present invention also relates to mounting structures for installing microphone modules in portable electronic devices.

This application claims priority on Japanese Patent Application No. 2006-244268, the content of which is incorporated herein by reference.

### Description of the Related Art

Conventionally-known portable electronic devices such as portable telephones and cellular phones are equipped with microphone modules for receiving and detecting sounds. For example, U.S. Patent Application Publication No. 2006/0116180 teaches an acoustic transducer module, i.e., a miniature silicon condenser microphone module adapted to micro-electromechanical systems (MEMS). This type of the microphone module includes an external connection terminal and a sound hole to enter sound, both of which are formed on the exterior surface of a housing having a hollow cavity. This microphone module is mounted on a mount portion of a circuit board included in the housing of a portable electronic device. The external connection terminal of the microphone module is brought into contact with a connection pad formed on the mount portion, thus establishing an electrical connection between the circuit board and the microphone module.

When the conventionally-known microphone module is installed in the portable electronic device, it is necessary to precisely mount the microphone module on the mount portion of the circuit board in such a way that a sound port of the housing of the portable electronic device, which allows the entry of sound, is positioned opposite to the sound hole of the housing of the microphone module. For this reason, it is necessary to appropriately change the positions of the external connection terminal and sound hole formed on the exterior surface of the housing of the microphone module in consideration of the position of the mount portion of the circuit board in relation to the sound port of the housing of the portable electronic device.

When the mount portion of the circuit board is positioned opposite to the sound port of the portable electronic device, it is necessary to form the sound hole and the external connection terminal on the opposite surfaces positioned opposite to each other within the exterior of the housing of the microphone module.

When the prescribed surface of the circuit board opposite to its mount portion is positioned opposite to the sound port of the portable electronic device, it is necessary to form both the sound hole and the external connection terminal on the same surface within the exterior of the housing of the microphone module. In this case, it is necessary to form a through-hole running through the circuit board in its thickness direction, via which the sound hole of the microphone module directly faces the sound port of the portable electronic device.

As described above, the conventionally-known microphone module is troublesome because it is necessary to change the positions of the external connection terminal and sound hole within the exterior in response to the position of the mount portion of the circuit board, which is positioned relative to the sound port of the portable electronic device. This reduces the degree of freedom in mounting the microphone module on the mount portion of the circuit board.

Since the conventionally-known microphone module is designed to suit the mount portion of the circuit board, the height of the microphone module substantially matches the projection height realized by the microphone module projecting from the mount portion of the circuit board. This causes a limitation for reducing the size of the housing in which the microphone module is mounted on the circuit board.

### SUMMARY OF THE INVENTION

It is an object of the present invention to provide a microphone module and its mounting structure, by which the degree of freedom is increased with respect to the mounting operation of the microphone module installed in the portable electronic device.

It is another object of the present invention to provide a portable electronic device having a reduced thickness, which realizes stable installation of the microphone module by use of the mounting structure.

In a first aspect of the present invention, a microphone module includes a housing having a hollow cavity and a sound hole, via which the hollow cavity communicates with the exterior, a microphone chip for detecting sound inside of the hollow cavity, a plurality of external connection terminals that are electrically connected to the microphone chip, and a plurality of extended portions that are horizontally extended from both ends of the housing in the direction perpendicular to the opening direction of the sound hole, wherein the external connection terminals are each elongated onto one of surfaces and backsides of the extended portions, and wherein the housing partially projects from the surfaces of the extended portions.

The housing of the microphone module is inserted into a recess or through-hole of the circuit board and is then mounted on the mount portion of the circuit board, wherein the depth of the recess is larger than the projection height of the housing that projects from the surfaces of the extended portions. Herein, the housing is inserted into the through-hole in such a way that the surfaces of the extended portions come in contact with the mount portion of the circuit board in the periphery of the through-hole, whereby the external connection terminals formed on the surfaces of the extended portions are brought into contact with connection pads that are formed in the periphery of the through-hole on the mount portion of the circuit board, thus reliably establishing an electrical connection between the microphone module and the circuit board. ,

Since the housing is partially held inside the through-hole of the circuit board, it is possible to reduce the projection height of the microphone module; it is possible to avoid the positional deviation of the microphone module relative to the circuit board; and it is possible to improve the mounting strength (or packaging strength) of the microphone module mounted on the circuit board.

In the above, the external connection terminals are each elongated onto the backside of the housing, which is positioned opposite to the surfaces of the extended portions. Since the external connection terminals are exposed on both of the surfaces and backsides of the extended portions, it is possible to reliably mount the microphone module without changing the positions of the external connection terminals in such a way that the surfaces of the extended portions are positioned opposite to the mount portion of the circuit board, alternatively, in such a way that the backsides of the extended portions are positioned opposite to the mount portion of the circuit board. In addition, even when the sound hole is opened in either the surface or backside of the housing, it is possible to reliably mount the microphone module on the circuit board in such a way that the sound hole is opened above the mount portion, or the sound hole is opened above the opposite surface of the circuit board opposite to the mount portion.

When the sound hole is formed at a height above the surfaces of the extended portions of the housing, a ring-shaped anti-sound-leak gasket is attached to the microphone module before the microphone module is mounted on the circuit board in such a way that the backsides of the extended portions are positioned opposite to the mount portion of the circuit board. That is, when the housing, which partially projects from the surfaces of the extended portions, is engaged inside of the ring-shaped anti-sound-leak gasket, the terminal portion of the anti-sound-leak gasket comes in contact with the surfaces of the extended portions; hence, it is possible to easily establish positioning of the anti-sound-leak gasket relative to the microphone module. This eliminates the necessity of attaching the anti-sound-leak gasket to the microphone module after the microphone module is mounted on the circuit board; hence, it is possible to reliably maintain an electrical connection between the microphone module and the circuit board.

In addition, the housing is constituted of a substrate for fixedly mounting the microphone chip on the surface thereof and a cover member that covers the surface of the substrate so as to form the hollow cavity, wherein the extended portions are formed using the substrate and are extended externally from the cover member. Furthermore, the extended portions are formed using a plurality of leads, each having a conductivity, which serve as the external connection terminals, wherein the housing is formed using a resin mold for sealing the leads.

Alternatively, the microphone module is basically constituted of a main body and a support for mounting and supporting the main body. The main body is constituted of a housing having a hollow cavity, a microphone chip that is arranged inside of the hollow cavity so as to detect sound, and a plurality of external connection terminals that are each electrically connected to the microphone chip. The housing has a sound hole for communicating the hollow cavity to the exterior, and the external connection terminals are each elongated onto the backside of the housing in the direction perpendicular to the opening direction of the sound hole. The support is constituted of a mount portion that is positioned opposite to the backside of the housing so as to mount the main body, a plurality of extended portions that are horizontally extended externally of the mount portion in the direction perpendicular to the opening direction of the sound hole, and a plurality of intermediate connection terminals that are elongated from the mount portion to the extended portions. The intermediate connection terminals are elongated onto the surfaces of the extended portions lying in parallel with the mount portion.

In the above, the main body of the microphone module is fixed to the support such that the backside of the housing is directed to the mount portion of the support, wherein the external connection terminals exposed on the backside of the housing are electrically connected to the intermediate connection terminals formed on the mount portion of the support. The intermediate connection terminals are each elongated toward the surfaces of the extended portions; this makes is possible to reliably mount the microphone module on the circuit board by simply directing the surface of the housing to the mount portion. Even when the main body of the microphone module is removed from the support, it is possible to reliably mount the main body on the circuit board by simply directing the backside of the housing toward the mount portion of the circuit board. This makes it possible to easily mount the microphone module on the circuit board by changing the direction of the housing relative to the mount portion of the circuit board without changing the positions of the external connection terminals. Even when the sound hole is opened in either the surface or backside of the housing, it is possible to reliably mount the microphone module on the circuit board such that the sound hole is opened above the mount portion of the circuit board or above the opposite surface of the circuit board.

Moreover, the heights of the surfaces of the extended portions measured from the mount portion are lower than the height of the main body mounted on the mount portion of the support. Herein, the housing is inserted into the through-hole of the circuit board such that the surfaces of the extended portions come in contact with the mount portion of the circuit board in the periphery of the through-hole, wherein the intermediate connection terminals formed on the surfaces of the extended portions are brought into contact with the connection pads formed on the mount surface of the circuit board in the periphery of the through-hole, thus electrically connecting the main body of the microphone module to the circuit board.

In a second aspect of the present invention, the microphone module is mounted on the mount portion of the circuit board by way of a mounting structure. Herein, the microphone module includes a housing having a hollow cavity and a sound hole for communicating the hollow cavity with the exterior, a microphone chip that is arranged inside of the hollow cavity so as to detect sound, a plurality of extended portions that are horizontally extended from the housing in the direction perpendicular to the opening direction of the sound hole, and a plurality of connection terminals that are formed in the extended portions and are electrically connected to the microphone chip. When the housing is inserted into a hole running through the mount portion of the circuit board, the extended portions come in contact with the mount portion so that the connection terminals come in contact with the connection pads formed on the mount portion of the circuit board, thus establishing an electrical connection between the microphone module and the circuit board.

In a third aspect of the present invention, the microphone module is mounted on the mount portion of the circuit board incorporated in the housing of a portable electronic device. When the housing is inserted into a hole running through the mount portion of the circuit board, the extended portions come in contact with the mount portion so that the connection terminals come in contact with the connection pads formed on the mount portion of the circuit board, thus establishing an electrical connection between the microphone module and the circuit board.

### BRIEF DESCRIPTION OF THE DRAWINGS

These and other objects, aspects, and embodiments of the present invention will be described in more detail with reference to the following drawings, in which:
FIG. 1 is a cross-sectional view showing the constitution of a microphone module in accordance with a first embodiment of the present invention;
FIG. 2 is a cross-sectional view showing a portable electronic device equipped with the microphone module;
FIG. 3 is a cross-sectional view showing another portable electronic device equipped with the microphone module;
FIG. 4 is a cross-sectional view showing a first variation of the portable electronic device shown in FIG. 2;
FIG. 5 is a cross-sectional view showing a second variation of the portable electronic device shown in FIG. 2;
FIG. 6 is a cross-sectional view showing the constitution of a microphone module in accordance with a second embodiment of the present invention;
FIG. 7 is a perspective view showing the structure of a support for mounting and supporting the microphone module shown in FIG. 6;
FIG. 8 is a cross-sectional view showing the constitution of a portable electronic device incorporating the microphone module of FIG. 6 by way of the support shown in FIG. 7;
FIG. 9 is a cross-sectional view showing the constitution of another portable electronic device incorporating the microphone module of FIG. 6;
FIG. 10 is a cross-sectional view showing a first variation of the portable electronic device shown in FIG. 8; and
FIG. 11 is a cross-sectional view showing a second variation of the portable electronic device shown in FIG. 8.

### DESCRIPTION OF THE PREFERRED EMBODIMENTS

The present invention will be described in further detail by way of examples with reference to the accompanying drawings.

### 1. First Embodiment

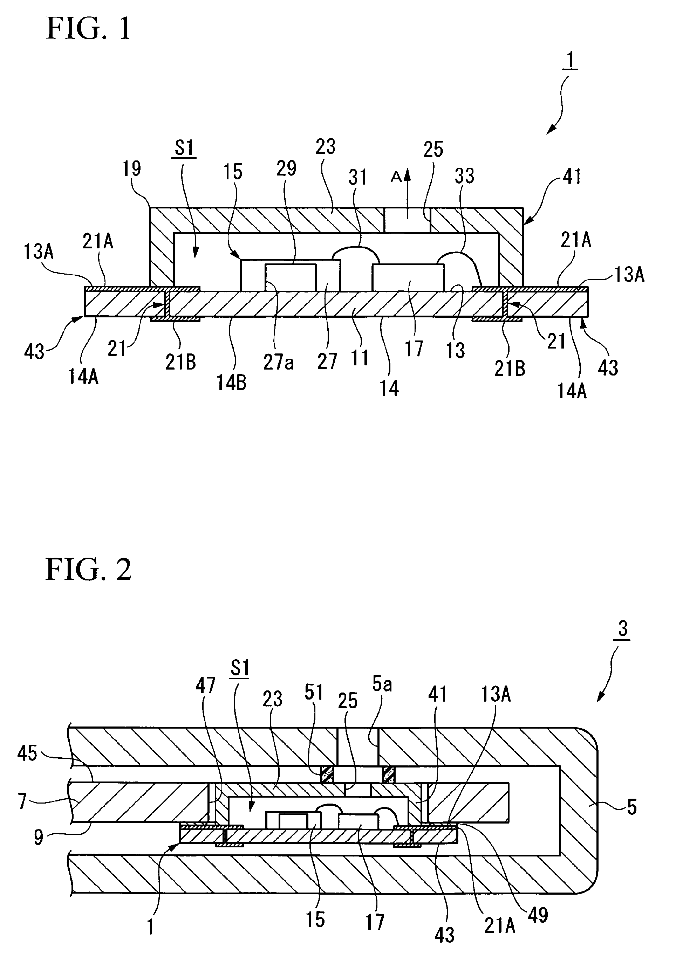

A microphone module 1 according to a first embodiment of the present invention will be described with reference to FIGS. 1 to 3.

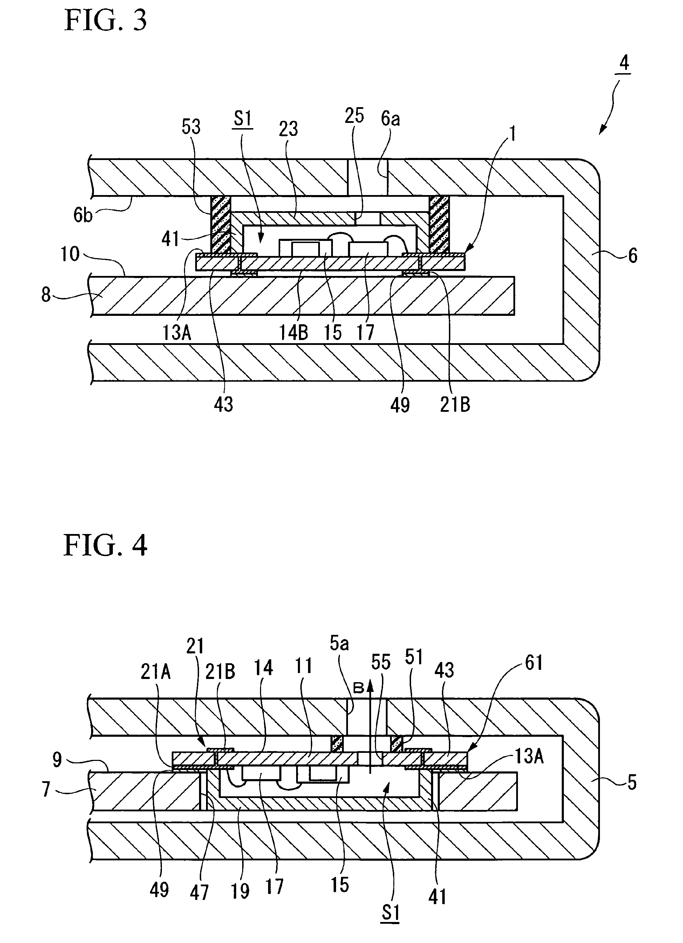

As shown in FIGS. 2 and 3, the microphone module 1 is designed to suit housings 5 and 6 of portable electronic devices (e.g., portable telephones) respectively. Specifically, the microphone module 1 is designed in a shape, which can be mounted on mount portions 9 and 10 of circuit boards 7 and 8 incorporated in the housings 5 and 6 of the portable electronic devices 3 and 4 respectively.

As shown in FIG. 1, the microphone module 1 includes a substrate 11 having a rectangular shape in plan view, a microphone chip 15 and a control circuit chip 17 fixed onto a surface 13 of the substrate 11, and a cover member 19, which covers a part of the surface 13 of the substrate 11 including the microphone chip 15 and the control circuit chip 17 so as to form a hollow cavity S together with the substrate 11. Herein, peripheral portions (or extended portions) of the substrate 11 are horizontally extended in opposite directions externally from the side walls of the cover member 19.

The substrate 11 has a multilayered wiring substrate, in which a plurality of external connection terminals 21 are formed on the substrate 11 so as to electrically connect the microphone chip 15 and the control circuit chip 17 to the circuit board 7 or 8 (see FIGS. 2 and 3). Each of the external connection terminals 21 are exposed on the surface 13 and a backside 14 of the substrate 11. Specifically, a first portion 2 1 A of the external connection terminal 21, which is exposed on the surface 13 of the substrate 11, is elongated horizontally from the inside to the outside of the cavity S1. A second portion 21 B of the external connection terminal 21, which is exposed on the backside 14 of the substrate 11, is positioned inward with respect to the extended portions of the substrate 11 extended externally from the side walls of the cover member 19.

A sound hole 25, which allows the cavity S1 to communicate with the exterior, is formed at a prescribed position of a top portion 23 of the cover member 19 that is positioned opposite to the surface 13 of the substrate 11. The opening direction A of the sound hole 25 lies vertical to the surface 13 of the substrate 11.

The microphone chip 15 is constituted such that a diaphragm 29 covers an inner hole 27a of a ring-shaped support 27. The diaphragm 29 detects sound by way of vibration; hence, the microphone chip 15 forms a sound pressure sensor that converts vibration of the diaphragm 29 into electric signals.

The microphone chip 15 is fixed on the surface 13 of the substrate 11 by use of a die bonding material (not shown) in such a way that the diaphragm 29 is positioned opposite to the surface 13 of the substrate 11 via the inner hole 27a.

The control circuit chip 17 drives and controls the microphone chip 15. Specifically, the control circuit chip 17 includes an amplifier for amplifying electric signals from the microphone chip 15, a digital signal processor (DSP) for processing electric signals in form of digital signals, and an analog-to-digital (A/D) converter. Similar to the microphone chip 15, the control circuit chip 17 is fixed on the surface 13 of the substrate 11 by use of the die bond material (not shown).

The control circuit chip 17 is electrically connected to the microphone chip 15 via a first wire 31, while it is also electrically connected to the first portion 2 1 A of the external connection terminal 21, which is exposed inside of the cavity S1, via a second wire 33. This makes it possible to electrically connect the microphone chip 15 to the external terminal 21.

In the microphone module 1 having the aforementioned constitution, a housing 41 forming the cavity S 1 and the sound hole 25 is constituted of the cover member 19 and the prescribed part of the substrate 11 covered with the cover member 19. The extended portions of the substrate 11, which are extended externally from the side walls of the cover member 19, are defined as extended portions 43, which are extended from the exterior of the housing 41 in horizontal directions perpendicular to the opening direction A of the sound hole 25.

Therefore, the microphone module 1 has the extended portions 43, which are reversely extended from both sides of the housing 41, whereby the housing 41 vertically projects from surfaces 13A of the extended portions 43, which correspond to the surface 13 of the substrate 11. The external connection terminals 21 are vertically elongated along the opening direction of the sound hole 25 from the surfaces 13A of the extended portions 43 to the backside 14B of the housing 41, which is positioned opposite to the surfaces 13A of the extended portions 43. In other words, the external connection terminal 21 does not exist in backsides 14A of the extended portions 43, which correspond to the backside 14 of the substrate 11.

In the manufacturing of the microphone module 1, the microphone chip 15 and the control circuit chip 17 are fixed onto the surface 13 of the substrate 11 in which the external connection terminals 21 are formed in advance; then, the microphone chip 15 is electrically connected to the control circuit chip 17 via the first wire 31, and the control circuit chip 17 is electrically connected to the external connection terminal 21; thereafter, the cover member 19 having the sound hole 25 is fixed onto the surface 13 of the substrate 11.

Next, the mounting structure of the microphone module 1, which is mounted on the mount portion of the circuit board of the microphone module 1, as well as a portable electronic device having the mounting structure will be described with reference to FIGS. 2 and 3.

The housing 5 of the portable electronic device 3 shown in FIG. 2 has a sound port 5a to allow the entry of sound, and the housing 6 of the portable electronic device 4 shown in FIG. 3 has a sound port 6a to allow the entry of sound. Herein, the portable electronic device 3 has a mounting structure for mounting the microphone module 1 on a mount portion 9 of a circuit board 7 at a prescribed position relative to the sound port 5a of the housing 5, and the portable electronic device 4 has a mounting structure for mounting the microphone module 1 on a mount portion 10 of a circuit board 8 at a prescribed position relative to the sound port 6a of the housing 6. These mounting structures differ from each other depending upon the positioning of the mount portions 9 and 10.

In the portable electronic device 3 shown in FIG. 2 in which a surface 45 of the circuit board 7 positioned opposite to the mount portion 9 is directed to the sound port 5a of the housing 5, a through-hole 47 running through the circuit board 7 in its thickness direction is formed in advance so as to allow the housing 41 to be inserted therein. When the housing 41 is inserted into the through-hole 47 from the mount portion 9, the surfaces 13A of the extended portions 43 come in contact with the mount portion 9 in the periphery of the through-hole 47. Connection pads 49 are formed in advance in connection with the mount portion 9 in the periphery of the through-hole 47; hence, the external connection terminals 21 exposed on the surfaces 13A of the extended portions 43 come in contact with the connection pads 49 so as to establish an electrical connection between the microphone module 1 and the circuit board 7. In the above, the microphone module 1 is arranged in such a way that the sound hole 25 is opened upwardly relative to the surface 45 of the circuit board 7 and is directed to the sound port 5a of the housing 5 of the portable electronic device 3.

A ring-shaped anti-sound-leak gasket 51 is inserted between the sound hole 25 and the sound port 5a, whereby it prevents sound, which is introduced into the housing 5 via the sound port 5a, from dispersing inside of the housing 5; thus, it is possible to efficiently propagate sound into the cavity S 1. The shape of the anti-sound-leak gasket 51 is not necessarily limited to the ring shape but can be arbitrarily designed in any shape suiting the shaping of the sound hole 25 and the sound port 5a.

In FIG. 2, the exterior of the top portion 23 of the microphone module 1 forming the sound hole 25 is placed substantially in the same plane as the surface 45 of the circuit board 7; but this is not a restriction. For example, the top portion 43 of the microphone module 1 can be placed at a position that is lower than the surface 45 of the circuit board 7, or it can be placed at a position projecting from the surface 45 of the circuit board 7.

In the portable electronic device 4 shown in FIG. 3 in which the mount portion 10 of the circuit board 8 is positioned opposite to the sound port 6a of the housing 6, it is unnecessary to form the through-hole 47, wherein the microphone module 1 is mounted on the circuit board 8 under the condition in which the backside 14B of the housing 41 is positioned opposite to the mount portion 10 of the circuit board 8 having the connection pad 49. This makes it possible for the second portion 21 B of the external connection terminal 21, which is exposed on the backside 14B of the housing 41, to come in contact with the connection pad 49, thus establishing an electrical connection between the microphone module 1 and the circuit board 8. The sound hole 25 of the microphone module 1 is opened upwardly above the mount portion 10 of the circuit board 8 so as to directly face the sound port 6a of the housing 6.

In the above, a ring-shaped anti-sound-leak gasket 53 is not directly held between the sound hole 25 of the microphone module 1 and the sound port 6a of the housing 6 but is directly attached to the microphone module 1. That is, the housing 41 of the microphone module 1, which vertically projects from the surfaces 13A of the extended portions 43 of the substrate 11, is inserted into the ring-shaped anti-sound-leak gasket 53 so that the lower portion of the anti-sound-leak gasket 53 is brought into contact with the surfaces 13A of the extended portions 43 of the substrate 11. Herein, the interior of the anti-sound-leak gasket 53 is shaped to substantially match the shape of the housing 41.

The aforementioned structure makes it easy to establish the prescribed positioning between the microphone module 1 and the anti-sound-leak gasket 53. Since the upper portion of the anti-sound-leak gasket 53 must be brought into contact with an interior surface 6b of the housing 6, the upper portion of the anti-sound-leak gasket 53 projects upwardly from the exterior of the top portion 23 of the housing 41 when the microphone module 1 is fixed into the portable electronic device 4.

When the microphone module 1 is installed in the portable electronic device 3 by use of the aforementioned mounting structure shown in FIG. 2, the housing 41 is inserted into and engaged with the through-hole 47 of the circuit board 7; hence, it is possible to reduce the projection height of the microphone module 1 projecting from the mount portion 9 of the circuit board 7. This prevents the microphone module 1 from disturbing parts of the portable electronic device 3 even when the circuit board 7 is arranged inside of the housing 5 of the portable electronic device 3; hence, it is possible to easily increase the degree of freedom in designing the portable electronic device 3. In addition, it is possible to easily reduce the thickness of the portable electronic device 3 including the circuit board 7.

Due to the insertion of the housing 41 into the through-hole 47 of the circuit board 7, it is possible to avoid the positional deviation of the microphone module 1 relative to the circuit board 7; hence, it is possible to improve the mounting strength (or packaging strength) of the microphone module 1 mounted on the circuit board 7.

In the portable electronic device 4 shown in FIG. 3 in which the microphone module 1 is mounted on the circuit board 8 in such a way that the backside 14B of the housing 41 is positioned opposite to the mount portion 10 of the circuit board 8, it is possible to attach the anti-sound-leak gasket 53 to the microphone module 1 in advance before the microphone module 1 is mounted on the circuit board 8. In other words, it is unnecessary to attach the anti-sound-leak gasket 53 to the microphone module 1 after the microphone module 1 is mounted on the circuit board 8. Thus, it is possible to maintain a reliable electrical connection between the microphone module 1 and the circuit board 8.

As described above, in the portable electronic device 3 shown in FIG. 2, the microphone module 1 is mounted on the circuit board 7 in such a way that surfaces 13A of the extended portions 43 are positioned opposite to the mount surface 9. Alternatively, in the portable electronic device 4 shown in FIG. 3, the microphone module 1 is mounted on the circuit board 8 in such a way that the backside 14B of the housing 41 is positioned opposite to the mount portion 10. This improves the degree of freedom in mounting the microphone module 1 on the circuit boards 7 and 8 respectively; hence, it is possible to further improve the degree of freedom in designing the portable electronic devices 3 and 4.

The microphone module 1 is constituted of the substrate 11 and the cover member 19, wherein the first portion 21A and the second portion 21B of the external connection terminal 21, which is used to establish an electrical connection with the circuit boards 7 and 8 respectively, are formed in connection with the substrate 11 only. This makes it possible to produce the microphone module 1 with ease.

The first embodiment is designed such that the sound hole 25 is formed on the top portion 23 of the cover member 19; but this is not a restriction. That is, it is simply required that the housing 41 be constituted of at least a part of the substrate 11 and the cover member 19, and the opening direction of the sound hole 25 be perpendicular to the extended portions 43 of the substrate 11. For this reason, the portable electronic device 3 shown in FIG. 2 can be modified in a variety of ways.

FIG. 4 shows a first variation of the portable electronic device 3 incorporating a microphone module 61, in which a sound hole 55 is formed to run through the substrate 11 in its thickness direction so as to allow the cavity S 1 to communicate the exterior. In this case, the surfaces 13A of the extended portions 43 lie opposite to and along the opening direction B of the sound hole 55.

In FIG. 4, the microphone module 61 having the sound hole 55, which is opened in the backside 14 of the substrate 11, is installed in the portable electronic device 3 in such a way that the surfaces 13A of the extended portions 43 are positioned opposite to the mount portion 9 of the circuit board 7. Similar to the portable electronic device 3 shown in FIG. 2, it is necessary to form the through-hole 47 for the insertion of the housing 41 in the circuit board 7. When the microphone module 61 is modified such that the backside 14 of the substrate 11 is positioned opposite to the mount portion 9 of the circuit board 7, it is necessary to form another through-hole (not shown) allowing the sound hole 55 to be opened with the exterior.

In the first embodiment, the external terminals 21 are formed on the backside 14B of the housing 41; but this is not a restriction. For example, the external connection terminals 21 can be formed on the backside 14A of the extended portions 43; or they can be formed on the backsides 14A of the extended portions 43 as well as the backside 14B of the substrate 11.

The external connection terminals 21, which are electrically connected to the microphone chip 15, are not necessarily formed on the backsides 14A of the extended portions 43 and the backside 14B of the substrate 11; that is, they can be formed on only the surfaces 13A of the extended portions 43. This modification allows the housing 41 to be reliably inserted into the through-hole 47 of the circuit board 17; hence, it is possible to reduce the projection height of the microphone module 1 or 61, which vertically projects from the mount portion 9 of the circuit board 7.

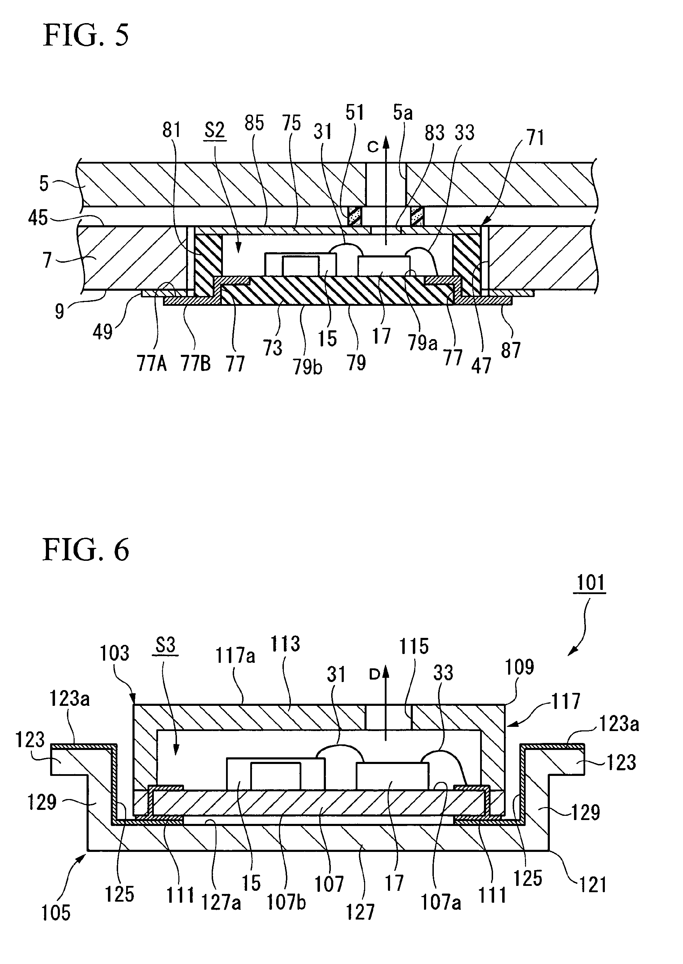

In the first embodiment, the microphone module 1 is constituted of the substrate 11 and the cover member 9; but this is not a restriction. FIG. 5 shows a second variation of the portable electronic device 3 incorporating a microphone module 71, which is constituted of a resin mold 73, a cover board 75, and a plurality of leads 77.

The resin mold 73 is constituted of a bottom 79 having a rectangular shape in plan view and a side wall 81 that projects vertically from the periphery of a surface 79a of the bottom 79. The microphone chip 15 and the control circuit chip 17 are fixed onto the surface 79a of the bottom 79.

The cover board 75 is fixed to the upper end of the side wall 81 and is thus positioned opposite to the surface 79a of the bottom 79. The cover board 75 joins the resin mold 73 so as to form a hollow cavity S2. A sound hole 83 is formed to run through the cover member 75 in its thickness direction so as to allow the cavity S2 to communicate the exterior. The sound hole 83 has an opening direction C perpendicular to the surface 79a of the bottom 79.

The leads 77 are each composed of a metal material having conductivity. The leads 77 are sealed with the resin mold 73 in such a way that the first ends thereof are exposed in the cavity S2, and the second ends thereof are extended from the side portion of the mold resin 73.

The control circuit chip 17 is electrically connected to the first end of the lead 77 via the second wire 33, thus allowing the microphone chip 15 to be electrically connected to the lead 77. In the microphone module 71, the prescribed portions of the resin mold 73 project externally from surfaces 77A at the second ends of the leads 77, while backsides 77B of the second ends of the leads 77 are formed in substantially the same plane as a backside 79b of the resin mold 73.

In the aforementioned constitution, a housing 85 including the cavity S2 and the sound hole 83 is formed using the resin mold 73 and the cover board 75. Extended portions 87, which are extended from the housing 85 in a horizontal direction perpendicular to the opening direction C of the sound hole 83, are formed using the extended portions of the leads 77, which are extended from the resin mold 73. The leads 77 serve as external connection terminals that are electrically connected to the microphone chip 15.

Similar to the microphone module 1, the microphone module 71 having the aforementioned constitution can be mounted on the mount portion 9 of the circuit board 7 that is positioned relative to the sound port 5a of the housing 5.

For example, when the opposite surface 45 of the circuit board 7 is directed toward the sound port 5a of the housing 5, the housing 85 is inserted into the through-hole 47 of the circuit board 7 from the mount portion 9, so that the surfaces 77A of the leads 77, which are extended from the resin mold 73, come in contact with the connection pads 49 formed on the periphery of the through-hole 47, thus establishing electric connection with the circuit board 7. In this state, the microphone module 71 is installed in the portable electronic device such that the sound hole 83 is opened upwardly above the opposite surface 45 of the circuit board 7 so as to directly face the sound port 5a of the housing 5.

The microphone module 71 offers effects similar to those of the microphone modules 41 and 61. In addition, it is possible to easily produce the microphone module 71, which is formed by sealing the leads 77 (serving as the external connection terminals and the extended portions 87) with the resin mold 73.

In the microphone modules 1, 61 and 71, the housings 41 and 85 project from the surfaces 13A and 77A of the extended portions 43 and 87 respectively, whereas they can project from the backsides 14A and 77B of the extended portions 43 and 87 respectively.

### 2. Second Embodiment

Next, a microphone module 101 according to a second embodiment of the present invention will be described in detail with reference to FIGS. 6 to 9, wherein parts identical to those of the microphone module 1 as well as parts identical to those of the portable electronic devices 3 and 4 are designated by the same reference numerals; hence, the descriptions thereof will be omitted as necessary.

As shown in FIG. 6, the microphone module 101 is constituted of a main body 103 and a support 105 for mounting and supporting the main body 103.

The main body 103 of the microphone module 101 is constituted of a substrate 107 having a rectangular shape in plan view, the microphone chip 15 and the control circuit chip 17 both fixed onto a surface 107a of the substrate 107, and a cover member 109 that entirely covers the surface 107a of the substrate 107 including the microphone chip 15 and the control circuit chip 17 so as to form a hollow cavity S3 with the substrate 107.

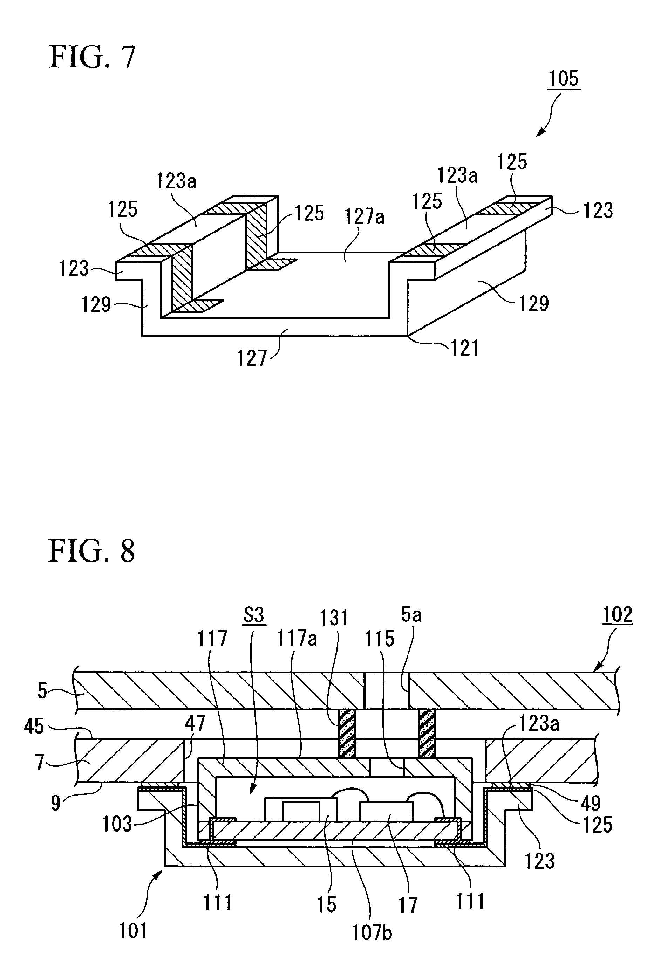

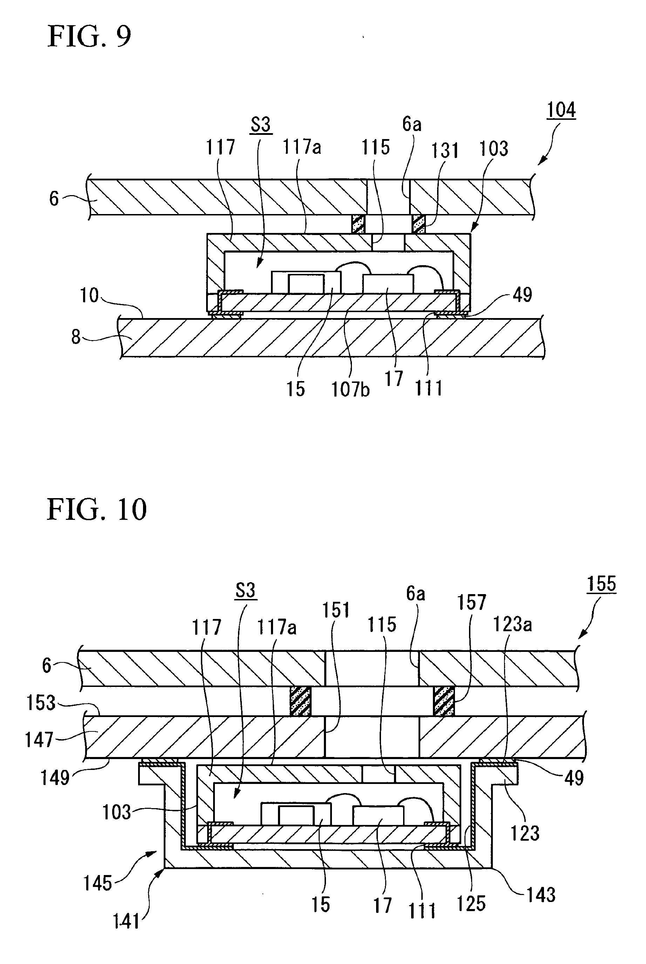

The substrate 107 is a multilayered wiring substrate, in which a plurality of external connection terminals 111 are formed to electrically connect the microphone chip 15 and the control circuit chip 17, which are arranged inside of the cavity S3, to the circuit boards 7 and 8 respectively (see FIGS. 8 and 9). The external connection terminals 111 are each exposed on both of the surface 107a and a backside 107b of the substrate 107, wherein the prescribed portions of the external connection terminals 111 exposed on the surface 107a of the substrate 107 are exposed inside of the cavity S3.

A sound hole 115 allowing the cavity S3 to communicate the exterior is formed at a prescribed position of a top portion 113 of the cover member 109, which is positioned opposite to the surface 107a of the substrate 107. The opening direction D of the sound hole 115 is perpendicular to the surface 107a of the substrate 107.

A housing 117 having the cavity S3 and the sound hole 115 is formed using the substrate 107 and the cover member 109. Herein, the backside 107b of the substrate 107 forms the backside of the housing 117, and the exterior surface of the top portion 113 having the sound hole 115 forms a surface 117a of the housing 117.

As shown in FIGS. 6 and 7, the support 105 is constituted of a mount portion 121 for mounting the main body 103 of the microphone module 101, a pair of extended portions 123, which are extended horizontally from the mount portion 121 in a direction perpendicular to the opening direction D of the sound hole 115, and a plurality of intermediate connection terminals 125, which are elongated from the mount portion 121 to the extended portions 123.

The mount portion 121 is constituted of a mount area 127a having a rectangular shape in plan view, on which the main body 103 of the microphone module 101 is mounted opposite to the backside 107b of the substrate 107, and a pair of side walls 129 that vertically project from both ends of the mount area 127a. Hence, the main body 103 of the microphone module 101 is precisely mounted on the mount area 127a defined between the side walls 129. The extended portions 123 are extended outwardly from the upper ends of the side walls 129; hence, they are positioned externally of the mount area 127a in plan view.

The intermediate connection terminals 125 are formed at the prescribed positions in contact with the external connection terminals 111 under the condition in which the main body 103 of the microphone module 101 is mounted on the mount area 127a of the mount portion 121. The main body 103 of the microphone module 101 is fixed to the support 105 in such a way that the backside 107b of the housing 117 is positioned opposite to the mount area 127a of the mount portion 121, thus electrically connecting the external connection terminals 111 to the intermediate connection terminals 125. Incidentally, the intermediate connection terminals 125 are each horizontally extended along the mount area 127a, vertically elongated along the side walls 129, and horizontally elongated along surfaces 123a of the extended portions 123, which are vertically elevated from the mount area 127a and which are horizontally extended externally of and in parallel with the mount area 127a.

Heights of the surfaces 123a of the extended portions 123 measured from the mount area 127a are determined such that they are lower than the height of the main body 103 of the microphone module 101 mounted on the mount area 127a.

Next, a mounting structure for mounting the microphone module 101 on the circuit board 7 as well as a portable electronic device 102 incorporating the microphone module 101 will be described with reference to FIG. 8.

In FIG. 8, the microphone module 101 is mounted on the mount portion 9 of the circuit board 7 installed in the portable electronic device 102 in such a way that the opposite surface 45 of the circuit board 7 opposite to the mount portion 9 is directed toward the sound port 5a of the housing 5. That is, when the housing 117 of the microphone module 101 is inserted into the through-hole 47 from the mount portion 9 of the circuit board 7, the surfaces 123a of the extended portions 123 come in contact with the mount portion 9 in the periphery of the through-hole 47. Since the connection pads 49 are formed on the mount portion 9 in the periphery of the through-hole 47, the intermediate connection terminals 125 formed on the surfaces 123a of the extended portions 123 are brought into contact with the connection pads 49, thus establishing an electrical connection between the circuit board 7 and the external connection terminals of the main body 103 of the microphone module 101.

In the above, the microphone module 101 is mounted on the circuit board 7 in such a way that the surface 117a of the housing 117 is directed to the mount portion 9; hence, the sound hole 115 of the microphone module 101 is opened vertically relative to the opposite surface 45 of the circuit board 7 so as to directly face the sound port 5a of the housing 5 of the portable electronic device 102.

A ring-shaped anti-sound-leak gasket 131 is held between the sound hole 115 and the sound port 5a, which are positioned opposite to each other. Thus, it is possible to prevent sound, which is introduced into the housing 5 via the sound port 5a, from being dispersed inside of the housing 5; that is, the ring-shaped anti-sound-leak gasket 131 makes it possible to efficiently propagate sound into the cavity S3.

In FIG. 8, the surface 117a of the housing 117 of the microphone module 101 is lower than the opposite surface 45 of the circuit board 7; but this is not a restriction. That is, the surface 117a of the housing 117 can be placed substantially in the same plane with the opposite surface 45 of the circuit board 7; alternatively, it can be placed higher than the opposite surface 45 of the circuit board 7.

FIG. 9 shows a portable electronic device 104 in which the microphone module 101 is mounted on the circuit board 8 whose mount portion 10 is directed to the sound port 6a of the housing 6, wherein the main body 103 of the microphone module 101 is removed from the support 105, which is not necessarily used, and is thus reliably mounted on the circuit board 8.

In the above, the through-hole 47 is not necessary so that the main body 103 of the microphone module 101 is simply mounted on the circuit board 8 under the condition in which the backside 107b of the housing 117 is positioned opposite to the mount portion 10 having the connection pads 49. Herein, the external connection terminals 111 exposed on the backside 107b of the housing 117 are brought into contact with the connection pads 49, thus establishing an electrical connection between the microphone module 101 and the circuit board 8. Herein, the microphone module 101 is installed in the portable electronic device 104 in such a way that the sound hole 115 is opened above the mount portion 10 of the circuit board 8 so as to directly face the sound port 6a of the housing 6.

In FIG. 8, similar to the microphone module 1, the microphone module 101, which is installed in the portable electronic device 102 by way of the aforementioned mounting structure, is arranged in such a way that the housing 117, which vertically projects above the surfaces 123a of the extended portions 123, is inserted into and engaged with the through-hole 47 of the circuit board 7, wherein it is possible to reduce the projection height of the microphone module 101, which vertically projects from the mount portion 9 of the circuit board 7.

Due to the insertion of the housing 117 into the through-hole 47 of the circuit board 7, it is possible to reliably avoid the positional deviation of the microphone module 101 relative to the circuit board 7; hence, it is possible to improve the mounting strength (or packaging strength) of the microphone module 101 mounted on the circuit board 7.

As shown in FIGS. 8 and 9, the main body 103 of the microphone module 101, which is detached from the support 105, can be reliably and easily mounted on the circuit board 7 and 8 respectively by appropriately changing the direction of the housing 117. Thus, it is possible to improve the degree of freedom in mounting the microphone module 101 on the circuit boards 7 and 8; and it is therefore possible to further improve the degree of freedom in designing the portable electronic devices 102 and 104.

In the second embodiment, the main body 103 of the microphone module 101, which is mounted on the mount area 127a of the mount portion 121, vertically projects above the surfaces 123a of the extended portions 123; but this is not a restriction. For example, as shown in FIG. 10, a support 141 is designed to completely incorporate the main body 103 of the microphone module 101 within a mount portion 143. Herein, the surfaces 123a of the extended portions 123 can be adjusted in height in such a way that they are substantially placed in the same plane as the surface 117a of the housing 117 having the sound hole 115. Alternatively, the heights of the surfaces 123a of the extended portions 123 are higher than the height of the main body 103 of the microphone module 101.

FIG. 10 shows a potable electronic device 155 incorporating a microphone module 145, which is mounted on a circuit board 147 in such a way that the surface 117a of the housing 117 is directed to a mount portion 149 of the circuit board 147. In this case, it is necessary to form a through-hole 151, which allows a sound hole 115 to communicate with the exterior, in the circuit board 147. Due to the aforementioned constitution of the microphone module 145 mounted on the circuit board 147, even when an opposite surface 153 of the circuit board 147 is positioned opposite to the sound port 6a of the housing 6, the sound hole 115 can directly face the sound port 6a via the through-hole 151 of the circuit board 147. In the portable electronic device 155, it is preferable that an anti-sound-leak gasket 157 be arranged between the sound port 6a of the housing 6 and the through-hole 151 of the circuit board 147, which are positioned opposite to each other.

As shown in FIG. 7, the mount portion 121 for mounting the microphone module 101 is constituted of the bottom 127 having a rectangular shape in plan view and the side walls 129 that vertically project from both ends of the bottom127; but this is not a restriction. That is, the mount portion 121 can be simply formed using the bottom 127 only. In this modification, the extended portions 123 are directly and horizontally extended from the periphery of the bottom 127. In short, this modification indicates that the support 105 is formed substantially in a rectangular shape, wherein when the main body 103 of the microphone module 101 is fixed onto the mount portion 121, the housing 117 entirely projects from the surfaces 123a of the extended portions 123.

In the aforementioned modification, the microphone module 101 can be mounted on the circuit board while the housing 117 is inserted into the through-hole of the circuit board; hence, it is possible to further reduce the projection height of the microphone module 101 vertically projecting from the mount portion of the circuit board.

In the mount portion 121, the intermediate connection terminals 125 are elongated onto the surfaces 123a of the extended portions 123; alternatively, they can be elongated onto the backsides of the extended portions 123, or they can be elongated onto the backside of the bottom 127 opposite to the mount area 127a. In this modification, the main body 103 of the microphone module 101 is unnecessarily removed from the support 105, wherein the surface 117a of the housing 117 having the sound hole 115 can be easily arranged on both of the mount portion 9 and opposite surface 45 of the circuit board 7.

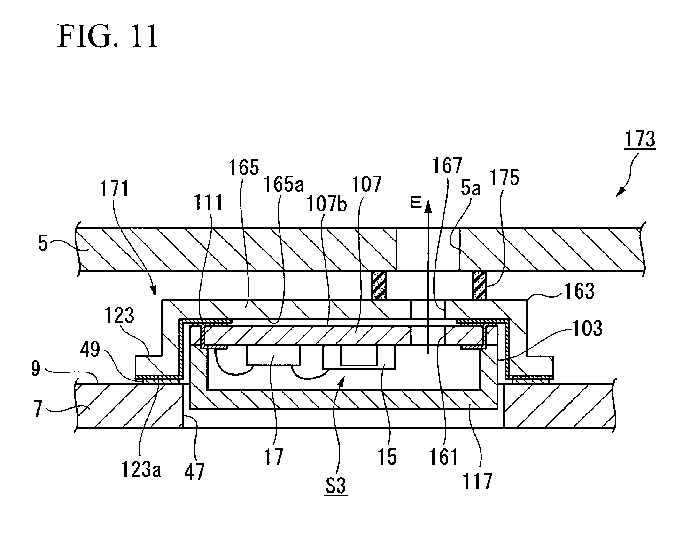

The external connection terminals 111 of the main body 103 of the microphone module 101 are exposed on the backside 107b of the housing 117 along the opening direction of the sound hole 115; but this is not a restriction. FIG. 11 shows a portable electronic device 173 incorporating a microphone module 171 whose main body 103 is mounted on the mount portion 9 of the circuit board 7 by way of a support 163, wherein they are exposed on the backside 107b of the housing 117 having a sound hole 161 lying along an opening direction E. That is, the sound hole 161 is formed at a prescribed position of a substrate 107 having the backside 107b, on which the external connection terminals 111 are exposed.

When the main body 103 of the microphone module 171, in which the sound hole 161 is opened on the backside 107b of the substrate 107, is mounted on a mount area 165a of the support 163, the sound hole 161 is exposed to communicate the exterior via an interconnection hole 167 running through a bottom 165 in its thickness direction.

When the microphone module 171 is installed in the portable electronic device 173, it is necessary to insert a gasket 175 between the interconnection hole 167 of the support 163 and the sound port 5a of the housing 5.

When the heights of the surfaces 123a of the extended portions 123, which are positioned opposite to a mount portion 165a of the support 163, is lower than the height of the main body 103 of the microphone module 171, it is necessary to form the through-hole 47 for use in the insertion of the housing 117 in the circuit board 7 on which the microphone module 171 is mounted.

In the microphone modules 1 and 101 according to the first and second embodiments, when the surfaces 13A and 123a of the extended portions 43 and 123 are brought into contact with the mount portion 9 of the circuit board 7, it is necessary to form the through-hole 47 running through the circuit board 7 in its thickness direction; but this is not a restriction. That is, the first and second embodiments require that at least a recess be formed in the mount portion 9 of the circuit board 7 so as to enable the insertion of the housings 41 and 117. Herein, it is necessary that the depth of the recess be greater than the projection heights of the housings 41 and 117, which vertically project from the surfaces 13A and 123a of the extended portions 43 and 123. When the sound holes 25 and 115 are positioned opposite to the bottom of the recess, it is necessary to additionally form a through-hole at the bottom of the recess so as to expose the sound holes 25 and 115 to the exterior.

Lastly, the present invention is not necessarily limited to the aforementioned embodiments, which can be further modified within the scope of the invention defined by the appended claims.

## Claims

1. A microphone module comprising:
a housing having a hollow cavity and a sound hole, via which the hollow cavity communicates an exterior;
a microphone chip for detecting sound, which is arranged inside of the hollow cavity;
a plurality of external connection terminals that are electrically connected to the microphone chip; and
a plurality of extended portions that are horizontally extended from both ends of the housing in a direction perpendicular to an opening direction of the sound hole,
wherein the plurality of external connection terminals are each elongated onto a surface or a backside of the extended portions, and
wherein the housing partially projects from the surfaces of the extended portions.

2. A microphone module according to claim 1, wherein the plurality of external connection terminals are each elongated onto a backside of the housing, which is positioned opposite to the surfaces of the extended portions.

3. A microphone module according to claim 1, wherein the housing is constituted of a substrate for fixedly mounting the microphone chip on a surface thereof and a cover member that covers the surface of the substrate so as to form the hollow cavity, and wherein the extended portions are formed using the substrate and are extended externally of the cover member.

4. A microphone module according to claim 1, wherein the plurality of extended portions are formed using a plurality of leads, each having a conductivity, which serve as the plurality of external connection terminals, and wherein the housing is formed using a resin mold for sealing the plurality of leads.

5. A microphone module comprising:
a main body, which is constituted of a housing having a hollow cavity, a microphone chip that is arranged inside of the hollow cavity so as to detect sound, and a plurality of external connection terminals that are each electrically connected to the microphone chip, wherein the housing has a sound hole for communicating the hollow cavity to an exterior, and wherein the plurality of external connection terminals are each elongated onto a backside of the housing in a direction perpendicular to an opening direction of the sound hole; and
a support for mounting and supporting the main body, wherein the support is constituted of a mount portion that is positioned opposite to the backside of the housing so as to mount the main body, a plurality of extended portions that are horizontally extended externally from the mount portion in a direction perpendicular to the opening direction of the sound hole, and a plurality of intermediate connection terminals that are elongated from the mount portion to the extended portions, and
wherein the intermediate connection terminals are elongated onto surfaces of the extended portions lying in parallel with the mount portion.

6. A microphone module according to claim 5, wherein heights of the surfaces of the extended portions measured from the mount portion are lower than a height of the main body mounted on the mount portion.

7. A mounting structure for mounting a microphone module on a mount portion of a circuit board, wherein the microphone module includes a housing having a hollow cavity and a sound hole for communicating the hollow cavity with an exterior, a microphone chip that is arranged inside of the hollow cavity so as to detect sound, a plurality of extended portions that are horizontally extended from the housing in a direction perpendicular to an opening direction of the sound hole, and a plurality of connection terminals that are formed in the extended portions and are electrically connected to the microphone chip, and wherein when the housing is inserted into a hole running through the mount portion of the circuit board, the extended portions come in contact with the mount portion so that the plurality of connection terminals come in contact with a plurality of connection pads formed on the mount portion of the circuit board, thus establishing an electrical connection between the microphone module and the circuit board.

8. A portable electronic device in which a microphone module is mounted on a mount portion of a circuit board incorporated in a housing, wherein the microphone module includes a housing having a hollow cavity and a sound hole for communicating the hollow cavity with an exterior, a microphone chip that is arranged inside of the hollow cavity so as to detect sound, a plurality of extended portions that are horizontally extended from the housing in a direction perpendicular to an opening direction of the sound hole, and a plurality of connection terminals that are formed in the extended portions and are electrically connected to the microphone chip, and wherein when the housing is inserted into a hole running through the mount portion of the circuit board, the extended portions come in contact with the mount portion so that the plurality of connection terminals come in contact with a plurality of connection pads formed on the mount portion of the circuit board, thus establishing an electrical connection between the microphone module and the circuit board.
